Europäisches Patentamt

European Patent Office

Office européen des brevets

(19)

(11) Publication number: **0 384 784**

**A2**

# EUROPEAN PATENT APPLICATION

(12)

(21) Application number: **90301984.2**

(22) Date of filing: **23.02.90**

(51) Int. Cl.⁵: **H01L 39/24**

(30) Priority: **24.02.89 US 315293**

(43) Date of publication of application:
**29.08.90 Bulletin 90/35**

(84) Designated Contracting States:
**AT CH DE FR GB IT LI NL**

(71) Applicant: **E.I. DU PONT DE NEMOURS AND COMPANY**
**1007 Market Street**
**Wilmington Delaware 19898(US)**

(72) Inventor: **Hsu, Che-Hsiung,**
**4803, Mermaid Boulevard,**
**Wilmington, Delaware 19808(US)**
Inventor: **McLain, Stephen James,**
**411, Snuff Mill Hill,**
**Hockessin, Delaware 19707(US)**

(74) Representative: **Woodman, Derek et al**
**Frank B. Dehn & Co. European Patent Attorneys Imperial House 15-19 Kingsway London WC2B 6UZ(GB)**

(54) **Process for preparing superconductive fibers of high density.**

(57) Process for preparing superconductive fiber from organometallic compound solution containing particulate superconductive oxide or certain precursor thereof.

EP 0 384 784 A2

## Process for Preparing Superconductive Fibers of High Density

### BACKGROUND OF THE INVENTION

Superconductive compositions having the formula

$MBa_2Cu_3O_x$

where M is selected from the group consisting of Y, Nd, Sm, Eu, Gd, Dy, Ho, Er, Tm, Yb and Lu, and x is from about 6.5 to 7.0 have been subjected to intensive investigation. It is expected that such compositions will find extensive use in a number of practical applications. For use in magnets and power transmission lines, it will be important that such materials be in the form of fibers (also referred to as wires) of high critical current densities $(J_c)$.

Several methods have recently been proposed for preparation of the fibers or wires. One involves combining of organometallic compounds of the metals in the required proportions in solution and spinning into fiber. The fiber is then fired in accordance with procedures well-known in the art to produce the superconductive fiber. A problem noted with such procedures has been that the resulting products have had relatively low density (high porosity) and as a result low critical current density $(J_c)$. The present invention seeks to remedy this deficiency.

### SUMMARY OF THE INVENTION

This invention provides a novel process for preparing superconductive fiber of improved critical current density and consisting of $MBa_2Cu_3$ superconductive oxide where M is a metal selected from the group of Y, Nd, Sm, Eu, Gd, Dy, Ho, Er, Tm, Yb and Lu, comprising forming a spinnable dispersion of 1) a particulate $MBa_2Cu_3$ superconductive oxide wherein M is as defined above, or 2) a particulate precursor of $MBa_2Cu_3$ superconductive oxide, said precursor consisting essentially of an amorphous M compound, CuO and barium carbonate in an organic solvent solution of organometallic compounds of M, Ba and Cu, the atomic ratio of M:Ba:Cu in said solution being 1:2:3, the particulate material being present in an amount of at least 25 wt.%, preferably 35 to 45 wt.% based on total particulate and organometallic compounds, forming fiber from the dispersion, and firing it to obtain a superconductive fiber.

### DETAILED DESCRIPTION OF THE INVENTION

The present invention represents a substantial improvement over the processes of the prior art employing organometallic compounds to produce superconductive fibers. The primary improved result has been obtaining fibers of high density (low porosity) with high current carrying capacity, high critical current density $(J_c)$, as compared with the products prepared by the prior art procedures.

Basically, the invention involves use of a solution of organometallic compounds providing M, Ba and Cu in the atomic proportions 1:2:3 as the only metals. Preferably M represents yttrium, (Y), in the organometallic compound. The solution can comprise one or more organometallic compounds; however, it is important that the solutions be of sufficient viscosity to be spinnable, i.e., to permit extrusion through a spinneret to form fiber. Such organometallic compounds and solutions thereof are known in the art. See, for example, Extruded Abstracts, High Temperature Superconductors II, Materials Research Soc. Meeting, April 5-9, 1988, pp. 97-100; Chemistry Letters, pp. 665-668, 1988, The Chemical Society of Japan; Poster 37 - SIIP-88 Superconductor Symposium, American Ceramic Society Meeting, May 1988, Cinn., Ohio, "Organometallic Precursors for the Fabrication of High $T_c$ Superconducting Fibers", Laine et al., 14 pages.

One of the materials useful in this invention is an organometallic salt of both Y and Ba, namely, $Ba_2y(OCH_2CH_2OEt)_7$.

It may be prepared as follows:

Barium metal (5.16g, 37.6mmol) was stirred in 75 ml of dried 2-ethoxyethanol until hydrogen evolution was complete. Yttrium isopropoxide (5.00g, 18.8 mmol) and 20 ml of dried toluene were added to the mixture. The mixture was heated at reflux for 5 min, filtered, and evacuated to remove the solvents. The resulting oil was redissolved in toluene and evacuated to dryness two more times to help remove residual 2-ethoxyethanol. The material was redissolved in pentane. Final purification was accomplished by filtering the pentane solution and evacuating it at $<10^{-3}$ torr to give 18.10 g (98%) of white crystalline solid corresponding to the above formula.

The organometallic compounds are dissolved in any suitable organic solvent. Tetrahydrofuran (THF) has been found satisfactory for the organometallic compounds used herein. Those skilled in the art will be aware of appropriate solvents and proportions to yield solutions of viscoelastic properties suitable for spinning.

To the organometallic solution is added particulate $MBa_2Cu_3$ superconductive oxide or certain precursors thereof. If a precursor is used, the metals M, Ba and Cu are in the precursor in the atomic ratio 1:2:3, the same as in the $M\ Ba_2Cu_3$ superconductive oxide. The particles to be added should be chemically homogeneous and of micron to submicron size, suitable for dispersing in the organometallic solution and subsequent spinning. They should be present in an amount of at least 25 wt. percent, preferably between 35 and 45 wt. percent, based on total amount of particulate plus organometallic compounds.

A precursor found particularly useful and which has been found to give higher critical current density is prepared by blending an aqueous mixture of M acetate, preferably yttrium acetate, copper acetate and a source of barium selected from barium hydroxide and barium acetate, removing excess solvent and calcining the product in air by heating to a temperature in the range of $450°C$ to $750°C$ and maintaining that temperature for at least one hour. Precursors prepared in other ways and containing an amorphous compound of M, CuO and barium carbonate would also be expected to yield the desired results.

After the particulate material is dispersed, the mix is extruded through a spinneret to form fiber and the fiber is fired in an oxygen-containing atmosphere, such as air, but preferably oxygen itself to a temperature of at least $900°C$ as is known in the art. Firing temperatures in excess of $1000°C$ and up to the incipient melting point, about $1025°C$ in the case of $YBa_2Cu_3$ superconductive oxide, have yielded products with significantly greater $J_c$ than those obtained at lower firing temperatures.

The resulting fibers represent useful forms of the superconductive oxides for magnetic, power transmission or other devices.

## TEST PROCEDURES

Critical Current Density ($J_c$) is defined as the threshold current which passes through a given cross-sectional area of a superconductor to transform the material from the superconductive state to the normal state. The measurement is done using a 4-probe method known in the art. A silver paste is used as electrode material to reduce contact resistance to about 5 ohm. The two inner electrodes are about 6 mm apart. While the fiber is immersed in liquid nitrogen, current is applied to the two outer electrodes. The voltage corresponding to the current applied through the two outer electrodes is measured between the two inner electrodes with an electrometer. As current is increased, at a certain point the sample is driven to the normal state. When the sample shows a voltage of 1 microvolt, the corresponding current is defined as threshold current. The threshold current normalized with the cross-section of the fiber sample is defined as $J_c$.

The following examples are illustrative of the invention and are not to be construed as limiting. EXAMPLE 1 constitutes a control.

## EXAMPLE 1

A viscous organometallic solution was prepared by dissolving 4.00 g (4.05 mmol) of $Ba_2Y$-$(OCH_2CH_2OEt)_7$ and 4.25 g (12.15 mmol) of copper 2-ethylhexanoate in tetrahydrofuran (THF). The copper 2-ethylhexanoate was purified by dissolving in a minimal amount anhydrous ether, filtering, and removing the ether by applying a vacuum. The THF was distilled from sodium benzophenone ketyl under an argon atmosphere. The solution was concentrated to a viscous dark blue liquid by applying a vacuum. Fibers could be easily drawn from the viscous solution with a spatula. The fiber diameters were in the range of 50 to 100 microns. The viscous solution was put into a 30 ml plastic syringe and extruded through the attached nozzle onto a "Teflon"-lined cardboard. The extrudates were dried in air on the cardboard at room temperature (RT). A portion of the air-dried extrudates was cut into small pieces (~6 cm long) which were placed in pure alumina boats. The alumina boats in turn were placed in a quartz container for firing in a Fisher #497 furnace. Oxygen was fed into the container during the entire firing cycle at a rate of 1.5 standard cubic feet per hour (SCFH). The firing cycle is as follows: room temperature (RT) to $220°C$ at $1°C/min$, 3 hr at $220°C$, $1°C/min$ to $450°C$, 2 hr at $450°C$, $1°C/min$ to $935°C$, 8 hr at $935°C$, cooled to $600°C$ at $5°C/min$, 2 hr at $600°C$, $5°C/min$ to $300°C$, 1 min at $300°C$, $2°C/min$ to RT. The fired extrudates show a sharp Meissner transition. Magnetic flux starts to be excluded at $90°K$ and is almost completely excluded at $75°K$. Although the fired extrudates are superconductive at the expected transition temperature for $YBa_2Cu_3$ oxide, they have extremely high porosity. The $J_c$ at $77°K$ is only 96 amps/cm$^2$.

## EXAMPLE 2

A superconductive precursor powder was prepared as follows:

(a) Copper acetate monohydrate (230.0g) was dissolved in 1.6 liter of purified water at about $75°C$, forming a cloudy blue-green solution. To this was added a clear solution of yttrium acetate hydrate, 128.6g dissolved in 0.6 liter of purified water at 75°C. A cloudy barium hydroxide solution (containing some white precipitate after its preparation by heating 242.2g of barium hydroxide octahydrate in 0.8 liter of purified water at 75°C) was added to the yttrium/copper mixture over a period of 5 minutes. The resulting brownish mixture was maintained at 75°C for 1 hour after which the water was evaporated by "spray" drying using a Buchi 190 mini spray dryer with a 0.7 mm nozzle.

(b) The dry powder from one or two batches at a time from procedure (a) was calcined in air, i.e. in an oxygen-containing atmosphere, according to the following heating cycle: 100°C - 1 hr, 20°C every 5 min to 240°C, 5°C every 10 min to 270°C, 20°C every 5 min to 320°C, 10°C every 10 min to 500°C, 500°C - 1 hr, then slowly cooled to room temperature. The calcined material is an intimate and homogeneous blend of stable $BaCO_3$, CuO and amorphous yttrium compounds.

(c) Seven batches treated as in (a) and (b) were hammermilled together to form a large lot. This lot was combined with six more batches and hammermilled to form an even larger lot. From this larger lot the precursor powder for this Example was taken.

An organometallic solution was prepared by dissolving 4.00 g (4.05 mmol) of $Ba_2Y$-$(OCH_2CH_2OEt)_7$ and 4.25 g (12.15 mmol) of purified copper 2-ethylhexanoate in dry THF. To the solution 4.72 g of precursor prepared as above was added.

The precursor dispersed very well and the mixture was concentrated under vacuum to a viscous black mixture. Fibers could be drawn easily from the dispersion with a spatula. The fiber diameters were in the range of 100 microns. The viscous dispersion was put into a 30 ml plastic syringe and extruded through the attached nozzle onto a "Teflon"-lined cardboard for air drying. Samples were prepared for oxygen firing as in Example 1 and were fired under the same conditions. The fired extrudates have all the characteristic X-ray powder diffraction peaks expected for the superconductive phase of $YBa_2Cu_3$ oxide. A comparison of a fracture surface of the fired extrudate with a fracture of the fired extrudate from EXAMPLE 1 shows that the extrudate from the organometallic solution containing superconductive oxide precursor is much denser. In addition, the fibers show a sharper transition in magnetic flux exclusion. Magnetic flux starts to be excluded at 95°K and is almost completely excluded at 80°K. The fibers also have a higher $J_c$ (318 vs 96 amps/$cm^2$) at 77°K.

The difference between this EXAMPLE and EXAMPLE 2 is the precursor loading. The dispersion was prepared according to the procedure described in EXAMPLE 2 but with a higher loading of precursor (6.29 g vs. 4.72 g). The concentrated dispersion could be drawn into fibers with a spatula. Fiber diameters were in the range of 100 microns. The dispersion was put into a 30 ml plastic syringe and extruded through an attached nozzle onto a "Teflon"-lined cardboard for air drying. The preparation of the samples of dried extrudate for firing and the firing conditions are the same as described in EXAMPLE 1. A fracture surface of the fired extrudate is similar in microstructure and density to the fired extrudate of EXAMPLE 2. The fired extrudates have a $J_c$ of 300 amps/$cm^2$ at 77°K, essentially equivalent to the $J_c$ shown for EXAMPLE 2.

## EXAMPLE 4

A long piece (~36 cm) of the unfired extrudate prepared in EXAMPLE 2 was used in this EXAMPLE. One end of the extrudate was taped perpendicularly to a metal rod. The rod was mounted horizontally to a post which has a knob for adjusting height of the rod. The base of the post was placed on the top of the Fisher #497 furnace. The sealed end of a Quartz tube (2.2 cm o.d., 37 cm long) was inserted through the vent hole on the top center of the furnace until it rested on the bottom of the furnace. The free end of the dried extrudate was inserted through the tube and advanced until it was about 7 cm above the bottom of the tube. Precaution was taken to ensure that the extrudate was not in contact with the tube to avoid sticking at high temperatures. The tube was fed with oxygen at a rate of 1.0 SCFH through a side tube. The firing cycle was as follows: RT to 220°C at 1°C/min, 2 hr at 220°C, 1°C/min to 450°C, 1 hr at 450°C, 1°C/min to 1000°C, 2 hr at 1000°C, cooled down to 600°C at 5°C/min, 2 hr at 600°C, 5°C/min to 300°C, 1 min at 300°C, 2°C/min to RT. The fired extrudate exhibits a sharp Meissner transition equivalent to the one described in EXAMPLE 2. Although the magnetic flux exclusion property is similar, the extrudate fired at the higher temperature (1000°C vs 935°C in EXAMPLE 2) does have a higher $J_c$ (622 vs 318 amps/$cm^2$) at 77°K. The result clearly demonstrates that high temperature firing has an advantage in attaining high $J_c$ fibers.

## EXAMPLE 3

## EXAMPLE 5

An organometallic solution was prepared by dissolving 4.50 g (4.56 mmol) of $Ba_2Y(OCH_2CH_2OEt)_7$ and 6.10 g of copper 2-ethylhexanoate (13.68 mmol)/2-ethylhexanoic acid mixture in THF. The copper hexanoate/acid mixture was obtained from the Strem Chemicals and contains 14.5% by weight copper. To this solution, 3.54 g of the precursor employed in EXAMPLE 2 was added. The precursor dispersed very well and the mixture was concentrated under vacuum to a viscous black dispersion. Fibers could be easily drawn from the dispersion with a spatula. The dispersion was put into a 20 ml plastic syringe and extruded through an attached nozzle onto a "Teflon"-lined cardboard. The extrudate remained flexible even with a prolonged air drying because of the presence of 2-ethylhexanoic acid which is not very volatile at ambient conditions. A long piece (~35 cm long) of the dried extrudate was mounted in the Fisher #497 furnace according to the manner described in EXAMPLE 4. The firing cycle described in EXAMPLE 4 was also used with the oxygen flow at 1.25 SCFH. The fired extrudate starts to exclude magnetic flux at 95°K and almost completely excludes flux at 85°K. It has a $J_c$ of 504 amps/cm$^2$ at 77°K.

## EXAMPLE 6

Superconductive oxide powder was prepared by blending three $YBa_2Cu_3$ superconductive oxide batches (A, B and C) in a grinding mill (Vortac). The major phase in all three batches was determined by x-ray analysis to contain Y/Ba/Cu in a ratio of 1/2/3. Only trace amounts of other phases were found.

To prepare Batch "A", 211.8g $Y_2O_3$, 980.1g $Ba(NO_3)_2$ and 447.6g CuO were dry mixed (Hockmeyer mixer) and placed in two trays (Coors Aluminaware). The mixture was calcined for 3 hours at about 970°C under an oxygen atmosphere. The temperature was lowered to 500°C and held 1 hour before cooling to room temperature. This batch was then ground in a stainless steel Waring blender.

In Batch "B" the same amounts of $Y_2O_3$, $Ba(NO_3)_2$ and CuO were mixed on the Hockmeyer using as little water as possible to form a smooth paste. The paste mixture was dried overnight at about 120°C. The dried mixture was broken up with a mortar and pestle and placed in a Coors Aluminaware tray. As before with Batch "A", Batch "B" was calcined under an oxygen atmosphere for 3 hours at about 970°C. The temperature was lowered to 500°C and held for 1 hour before cooling to room temperature. This calcined batch was then broken up with a mortar and pestle and ground further using zirconia beads.

Batch "C" was prepared like "B" except that after calcining the batch was broken up using a stainless steel blender prior to grinding with zirconia beads.

An organometallic solution was prepared by dissolving 4.00 g (4.05 mmol) of $Ba_2Y(OCH_2CH_2OEt)_7$ and 4.25 g (12.15 mmol) of copper 2-ethylhexanoate in THF. In it was dispersed 4.72 g of the above described superconductive oxide powder. The mixture was concentrated under vacuum to a viscous black mixture. The dispersion was put into a 30 ml plastic syringe and extruded through an attached nozzle onto a "Teflon"-lined cardboard for air drying. The dried extrudate were cut into small pieces (6 cm long) which were placed in alumina boats for oxygen firing. The firing cycle and oxygen flow rate were the same as those described in EXAMPLE 2. The fired sample is denser than the fired extrudate described in EXAMPLE 1 but more porous than the sample described in EXAMPLE 2. The $J_c$ of the fired extrudate is also lower (140 vs 318 amps/cm$^2$) for the fired extrudate in EXAMPLE 2. The result clearly demonstrates that the precursor is a much better particulate for dispersion in the organometallic solution for attaining dense superconductive fibers with high $J_c$.

## Claims

1. A process for preparing superconductive fiber of improved critical current density and consisting of $MBa_2Cu_3$ superconductive oxide wherein M is a metal selected from the group consisting of Y, Nd, Sm, Eu, Gd, Dy, Ho, Er, Tm, Yb and Lu, comprising forming a spinnable dispersion of 1) a particulate $MBa_2Cu_3$ superconductive oxide where M is as defined above, or 2) a particulate precursor of $MBa_2Cu_3$ superconductive oxide, said precursor consisting essentially of an amorphous M compound, CuO and barium carbonate, in an organic solvent solution of organometallic compounds of M, Ba and Cu, the atomic ratio of M:Ba:Cu in said solution being 1:2:3, and the particulate material being present in an amount of at least 25 wt. percent of the total amount of particulate plus organometallic compounds forming fiber from the dispersion and firing it to obtain a superconductive fiber.

2. A process according to claim 1 wherein the firing temperature is in excess of 1000°C.

3. A process according to claim 1 or 2 wherein the fiber is fired in oxygen.

4. A process according to claim 1, 2 or 3 wherein M is yttrium.

5. A process according to claim 1, 2, 3 or 4 wherein a particulate precursor of the superconductive oxide is employed.